# EUROPEAN PATENT APPLICATION

(11) **EP 4 711 786 A1**
(43) Date of publication of application: **18.03.2026**
(21) Application number: 24200636.9
(22) Date of filing: 16.09.2024
(51) Int. Cl.: G01R 31/389, G01R 31/367

(54) **PARAMETERIZING A HALF-CELL EQUIVALENT CIRCUIT MODEL OF A LITHIUM-ION BATTERY CELL BASED ON FULL-CELL MEASUREMENTS**

(71) Applicant: TWAICE Technologies GmbH, 80807 München (DE)
(72) Inventor: KIRST, Cedric, 81375 München (DE); HALDER, Anika, 80634 München (DE); GIELER, Philipp, 81539 München (DE); KARGER, Alexander, 81667 München (DE); PHAM, Bastian, 81373 München (DE); PUTZ, Reinhard, 80809 München (DE); RAMOS ZAYAS, Juan, 80336 München (DE); AYGÜL, Deniz, 80802 München (DE); SINGER, Jan Patrick, 80336 München (DE)
(74) Representative: Kraus & Lederer PartGmbB

(57) **Abstract**

The present disclosure relates to techniques for determining multiple parameterized values of an equivalent circuit model (ECM) that represents a Lithium-ion battery cell, enabling accurate simulation of various electrochemical processes occurring within the cell. A half-cell ECM is considered. The ECM can parameterized optimized by considering one or more constraints related to the electric potential of the negative electrode, breaking symmetry between parameter values associated with positive and negative electrodes. This results in improved accuracy of the ECM for simulating Lithium plating onset thresholds at different SOC values, enabling determination of optimized charging profiles or load constraints that avoid increased aging of the battery.

## Description

### TECHNICAL FIELD

Various examples disclosed herein relate to modeling Lithium-ion battery cells. Various examples particularly relate to parametrizing an equivalent circuit model of a Lithium-ion battery cell.

### BACKGROUND

Lithium-ion batteries (LIBs) are widely used as electrical energy storage, e.g., as traction batteries in electrical vehicles or in consumer electronics.

LIBs are modeled for monitoring their operation and/or for predicting their ageing. One type of model is the equivalent circuit model (ECMs). ECMs are one of the most widely used electrical models for LIBs, because of their small number of parameters - e.g., if compared to electrochemical models such as Doyle-Fuller-Newman (DFN) models (based on a system of partial differential equations that represent conservation of charge, mass transport through diffusion and migration, and electrochemical kinetics) or black-box data-driven models. ECMs include one or more resistor-capacitor (RC) elements; these RC elements have a certain frequency response to thereby describe the frequency-resolved impedance values of the LIB cell, which is a key parameter for assessing the condition of LIBs.

The parameter values of an ECM vary from battery type to battery type. Thus, for each type of battery cell, the respective ECM needs to be parameterized. For instance, the frequency-resolved impedance values of a LIB cell of a first type will differ from the frequency-resolved impedance values of a LIB cell of a second type. Thus, it is necessary to use different capacitance values for the capacitors and different resistance values for the resistors of the one or more RC elements. Typically, calibration measurements can be performed to measure the frequency-resolved impedance values of the LIB cell and then the resistance and capacitance values of the ECM can be adjusted so that the frequency-resolved impedance values of the ECM match and fit to the measured frequency-resolved impedance values of the LIB cell.

A particular type of ECM is a half-cell ECM. Here, the positive and negative electrodes are separately modeled. I.e., for each of the positive and negative electrode, the ECM includes one or more respective RC elements. Thus, the ECM includes at least two RC elements: one or more RC elements for the negative electrode (anode) and one or more RC elements for the positive electrode (cathode). By separately modeling the positive and negative electrodes, electrode-specific ageing mechanisms can be accurately predicted. This, in particular, applies to deposition of metallic Lithium at the negative electrode, which is referred to as Lithium plating.

Zhang, Cheng, et al. "Real-time estimation of negative electrode potential and state of charge of LIB based on a half-cell-level equivalent circuit model." Journal of Energy Storage 51 (2022): 104362 discloses a technique of parameterizing a half-cell ECM. This technique faces certain restrictions. In particular, it is necessary to modify the battery cell by introducing a Lithium reference electrode to measure the per-electrode potential. This requires opening the battery cell. This is time consuming and requires significant manual work. Further, the LIB cell typically cannot be used after performing the calibration measurements.

### SUMMARY

Accordingly, a need exists for advanced techniques of parametrizing half-cell ECMs of LIB cells. In particular, a need exists for such techniques that do not rely on invasive measurements.

This need is met by the features of the independent claims. The features of the dependent claims define embodiments.

One aspect of the present disclosure relates to a method of parameterizing an ECM of a LIB cell. The ECM includes one or more respective RC elements for each of a positive electrode of the LIB cell and a negative electrode of the LIB cell. Thus, the ECM is a half-cell ECM.

The method comprises performing, for multiple state-of-charge (SOC) values of the LIB cell, first full-cell measurements to determine, for each of the multiple SOC values, a respective representation of frequency-resolved impedance values of the LIB cell.

SOC is a metric used to express the current charge level of a battery relative to its maximum capacity, typically expressed as a percentage.

Thus, the frequency-resolved impedance of the LIB cell is measured. In other words, the frequency response of the LIB cell is measured, referring to how the impedance of a LIB cell changes across different frequencies when subjected to an alternating current signal. This response provides insights into various electrochemical processes occurring within a battery.

The method further comprises performing at least one second full-cell measurement to determine, for one or more current amplitudes, respective threshold SOC values associated with an onset of Lithium plating.

Lithium plating refers to the deposition of metallic Lithium on the anode surface of a LIB during charging conditions where the anode potential is driven below the Lithium reference potential, i.e., Lithium metal reduction/crystallization potential. Lithium plating typically occurs at higher charging rates; it also depends on the SOC value.

Additionally, the method comprises performing an optimization of parameter values of the ECM to fit the frequency-resolved impedance values. The optimization is performed under at least one constraint. The at least one constraint fixes, for the respective one or more current amplitudes and threshold SOC values, a potential defined by the one or more resistor-capacitor blocks of the negative electrode to a predefined Lithium reference potential.

An iterative numerical optimization can be used that minimizes or maximizes a goal function. That goal function describes the difference between the measured frequency-resolved impedance values of the first full-cell measurement on the one hand and the modeled frequency-resolved impedance values obtained from the ECM on the other hand.

Such techniques are based on the finding that the potential of the negative electrode is known at the onset of Lithium plating. Lithium plating commences when the potential equals the Lithium reference/crystallization potential. Thus, instead of intercalating Lithium ions into the host formed by the material of the negative electrode (typically Graphite), Lithium deposits as solid metallic Lithium. The Lithium reference potential is well known in literature. It is a predefined value. Then, at these operating points, it is possible to break a symmetry between the parameter values associated with the positive electrode and the negative electrode, because the constraint selectively acts upon the parameter values of the RC elements of the negative electrode (but not on the parameter values of the RC elements of the positive electrode).

It has been found that by introducing the electrode-asymmetric constraint at the onset of Lithium plating, a reliable and electrode-specific parameterization of the ECM becomes possible - without the need of opening the LIB cell. Rather, consumer-grade LIB cells can be used and their integrity can be maintained. No specific test electrodes etc. are required. It is simply possible to perform full-cell measurements, i.e., contacting the positive and negative terminals of the LIB cell as in normal operation. This speeds-up the preparation time required for the measurement and does not compromise the integrity of the LIB cell.

A computing device comprising a processor and a memory is disclosed. The processor, upon loading program code from the memory, is configured to execute the program code. The processor, upon executing the program code, may perform a method as disclosed above.

It is to be understood that the features mentioned above and those yet to be explained below may be used not only in the respective combinations indicated, but also in other combinations or in isolation without departing from the scope of the invention.

### BRIEF DESCRIPTION OF THE DRAWINGS

FIG. 1 schematically illustrates a half-cell ECM according to various examples.
FIG. 2 is a flowchart of a method according to various examples.
FIG. 3 is a plot of a distribution of relaxation times representing a frequency-resolved impedance value of a LIB cell according to various examples.
FIG. 4 schematically illustrates current and voltage values for multiple frequency-domain measurements at different current amplitudes disturbed by small sinusoidal signals according to various examples.
FIG. 5 schematically illustrates current and voltage values for multiple time-domain measurements employing current pulses at different current amplitudes according to various examples.
FIG. 6 schematically illustrates the real part of the impedance of the LIB cell for multiple state of charge values as derived from the measurements of FIG. 4 and the measurements of FIG. 5, respectively.
FIG. 7 schematically illustrates a system including a computing device and a measurement equipment according to various examples.

### DETAILED DESCRIPTION

Hereinafter, techniques of setting parameter values of a half-cell ECM are disclosed. This is described for a LIB cell. The LIB cell may have a Graphite anode. In a first step, the frequency-resolved impedance of the LIB cell is measured; this is repeated for multiple SOC values. For instance, conventional electrochemical impedance spectroscopy (EIS) can be employed, i.e., (a first) full-cell measurements in frequency domain by tapping the positive and negative terminals of the LIB cell. Alternatively or additionally, it would be possible to use time-domain measurements of current flow between the negative and positive terminals. In a second step, the particular SOC values and current amplitudes at which Lithium plating commences are identified. This can be achieved based on the investigation of the characteristics of a frequency-domain Nyquist plot of the impedance or peaks of a time-domain response of the LIB cell. A separate (second) full-cell measurement can be executed to test multiple current amplitudes / SOC values. This second measurement yields multiple current amplitudes and SOC values at which the electric potential of the negative electrode is known to equal the Lithium reference potential; this can be utilized to break a symmetry between the resistance and capacitance values of the RC elements of the ECM.

For such measurements, measurement equipment can be used that measures voltage and current between the negative and positive currents. Lock-in techniques and/or time-resolved measurements may be used. An example measurement equipment includes automatic dynamic switching current ranges (switching without interruption). A relative accuracy of at least 0.33% within a measurement range from 60µA to 20A may be desirable.

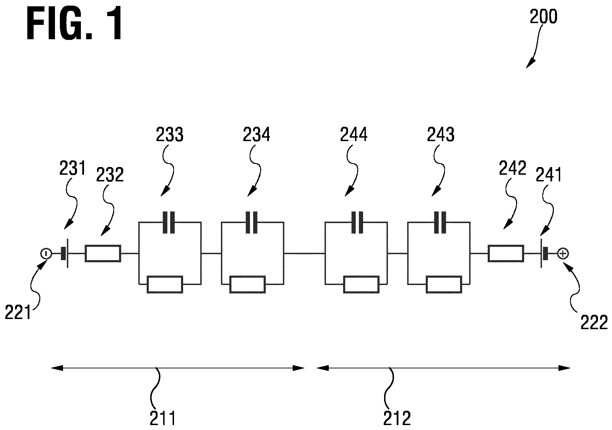

FIG. 1 schematically illustrates an ECM 200 according to various examples. The ECM 200 includes multiple elements associated with the negative electrode 211 and multiple elements associated with the positive electrode 212. Specifically, the ECM 200 includes, for the negative electrode 211, a voltage source 231, a resistor 232, and a series connection of two RC elements 233, 234. Similarly, the ECM 200 includes, for the positive electrode 212, a voltage source 241, a resistor 242, and a series connection of two RC elements 243, 244.

While in FIG. 1, each of the positive electrode 212 and the negative electrode 211 include two respective RC elements 233, 234, 244, 243, the number of RC elements is variable. Generally, the number of RC elements may be chosen as small as possible but as big as necessary to model all relevant electrochemical processes at the respective electrode 211, 212.

Furthermore, the negative electrode 211 and the positive electrode 212 are symmetrically modeled by the ECM 200 in the scenario FIG. 1. It would be possible to include more or fewer RC elements in the negative electrode 211 if compared to the positive electrode 212.

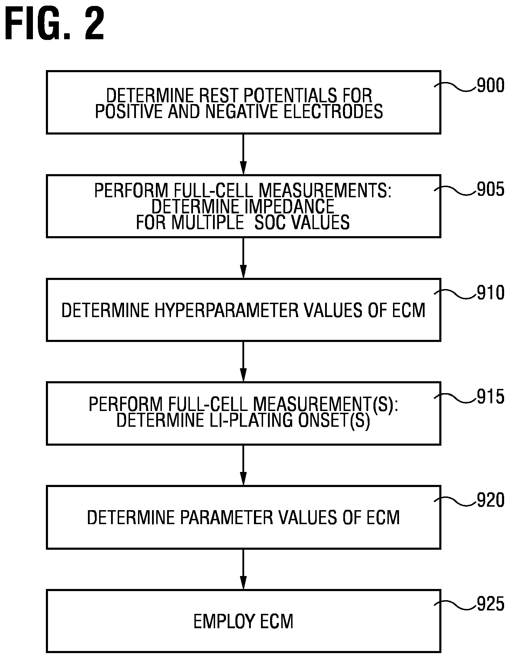

Hereinafter, techniques are disclosed that enable parametrizing the ECM 200 based on full-cell measurements, i.e., measurements that are implemented by ing, only, the negative terminal 221 and the positive terminal 222 of the intact battery cell. Details are disclosed in connection with FIG. 2.

FIG. 2 is a flowchart of a method according to various examples. The method pertains to parametrizing a half-cell ECM such as the ECM 200 discussed above in connection with FIG. 1.

At optional box 900, rest potentials, i.e., potentials in a relaxed open-circuit state (no current flow), are determined for each of the negative electrode and the positive electrode. Lookup tables can be established that link the respective potentials to state of charge (SOC) values. For instance, box 900 can include full-cell measurements of the open-circuit voltage across a customer grade LIB cell. Attributing these open-circuit voltage on cell-level to the positive and negative electrodes is out of scope of the subject disclosure, but generally known to the skilled person. An example technique is disclosed in European patent application 23 202 515.5 (filed October 9, 2023). These rest potentials can then be attributed to the voltage sources of the ECM (cf. FIG. 1: voltage source 231 and voltage source 241).

Box 900 is optional, because such rest potentials may be predefined.

Next, at box 905, (first) full-cell measurements are performed at multiple SOC values. These measurements may be performed by tapping the positive terminal and negative terminal of a customer-grade LIB cell.

Based on these full-cell measurements of box 905, a representation of frequency-resolved impedance values of the LIB cells is determined for each SOC value. For instance, such representation can be in time domain or can be in frequency domain. For instance, a Nyquist plot can be used for the representation in frequency domain. In time domain, a time-domain distribution of relaxation times (DRT) of the LIB cell can be determined. For instance, the DRT may be expressed by a superposition of responses of an infinite number of RC elements with continuous relaxation times. Such a representation has the benefit of clearly indicating time constants / frequencies of all dominant electrochemical processes in the LIB cell.

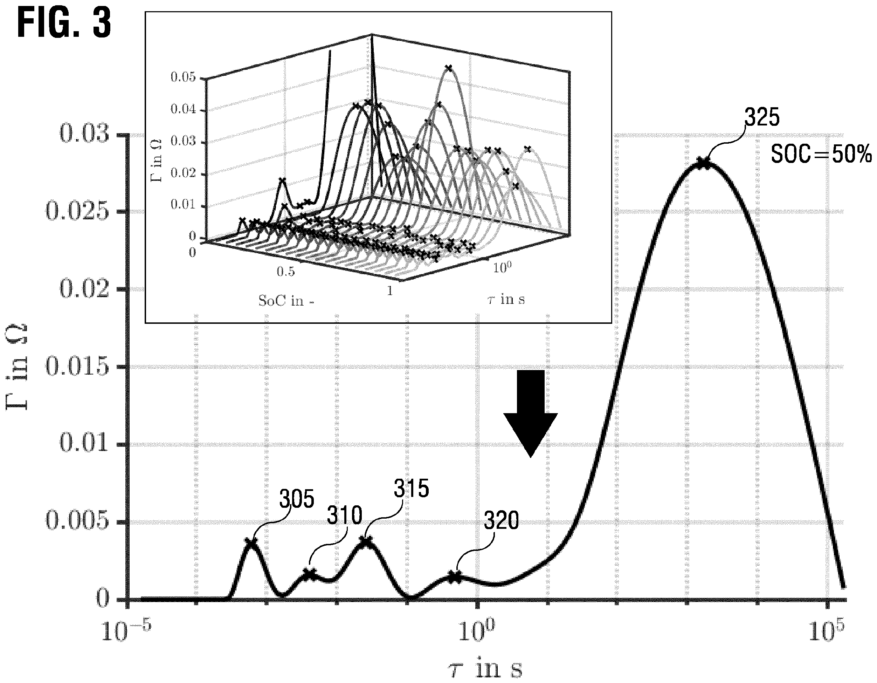

The measurements of box 905 may be in time domain or frequency domain. For instance, EIS may be employed. It would, alternatively or additionally, be possible to employ time-resolved measurements. For instance, techniques as disclosed in Wildfeuer, Leo, Philipp Gieler, and Alexander Karger. "Combining the distribution of relaxation times from EIS and time-domain data for parameterizing ECMs of Lithium-ion batteries." Batteries 7.3 (2021): 52 may be employed. FIG. 3 illustrates an example time-domain distribution of relaxation times (here, at a given SOC value of 0.5; similar distributions can be captured for multiple SOC values). FIG. 3 illustrates the impedance in Ohm as a function of the relaxation time *τ* in seconds. In FIG. 3, this time domain distribution is expressed by a superposition of responses of an infinite number of RC elements whose parameter values are fitted to respective experimental data. As can be seen from FIG. 3, the respective response curve has five peaks 305, 310, 315, 320, 325. These peaks correspond to different electrochemical processes in the LIB cell. Peaks 315 and 320 correspond to charge-transfer resistance at the negative and positive electrode, respectively; peak 325 corresponds to charge diffusion at, both, the positive and negative electrode (the respective electrode-specific processes are superimposed). The high-frequency peaks 305, 310 correspond to the formation of the solid-electrolyte interfaces (SEI) at the negative and positive electrodes, respectively. Such measurements are executed for multiple SOC values (cf. inset of FIG. 3). For varying SOC values, the position of the peaks shift. Some peaks may be superimposed for some SOC values.

Reference is again made to FIG. 2. In box 910, it is optionally possible to determine one or more hyperparameter values of the ECM. In particular, it is possible to determine, at box 910, a count of RC elements. The count of RC elements for each of the positive electrode and the negative electrode can be set to equal the count of dominant electrochemical processes, as determined from the representation of the frequency-resolved impedance values as obtained from box 905. For instance, in the scenario of FIG. 3, there is a total of four peaks visible, corresponding to three dominant electrochemical processes per electrode; so that the number of RC elements can be set to three. By such techniques, it is ensured that the number of free parameters of the ECM is set as small as possible, but as large as necessary to accurately model the cell.

Box 910 is optional. In some scenarios, the hyperparameter values of the ECM may be predefined.

The full-cell measurements performed at box 915 can be generally at higher current amplitudes if compared to the full-cell measurements performed at box 905. For instance, the current amplitudes used for the full-cell measurements performed at box 905 can be at current amplitudes below 0.5C; while the current amplitude used for the full-cell measurements performed at box 915 can be at least partly above 0.5C.

At box 915, one or more (second) full-cell measurements are performed to determine threshold SOC values for one or more current amplitudes. But at these operating points, i.e., pairs of threshold SOC values and current amplitudes, Lithium plating commences. For instance, techniques as disclosed in Koleti, Upender Rao, Truong Quang Dinh, and James Marco. "A new on-line method for Lithium plating detection in Lithium-ion batteries." Journal of power sources 451 (2020): 227798. Alternatively or additionally, technique as disclosed in Straßer, Andreas, Alexander Adam, and Jiahao Li. "In operando detection of Lithium plating via electrochemical impedance spectroscopy for automotive batteries." Journal of Power Sources 580 (2023): 233366 may be employed.

In particular, it would be possible to combine a full-cell measurement in frequency domain with another full-cell measurement in time-domain. This has the advantage of capturing electrochemical processes, both, at large as well as small frequencies at high resolution.

For a measurement executed in frequency domain, it is possible to apply a constant current having a certain current amplitude. Superimposed to the constant current is a relatively small sinusoidal variable current at the respective tested frequency. For a measurement to be executed in time domain, a short current pulse is applied. The current pulse can have a certain pulse shape associated with a certain frequency range.

The current amplitudes can be relatively high, e.g., higher than 0.5C or even higher than 0.7C, to reliably find the onset of Lithium plating.

It may be helpful to set the frequency or frequency ranges tested by the measurements at box 915 based on the frequencies or frequency ranges at which the dominant electrochemical processes of the LIB cell take place. In particular, it has been observed that the onset of Lithium plating can be observed particularly well at frequencies associated with the transition regime between charge transfer (peaks 315, 320 in FIG. 3) and diffusion (peak 325 in FIG. 3); such frequency regime is labeled by the arrow in FIG. 3. This frequency regime can shift to smaller or higher frequencies, depending on the SOC value. This is why it is helpful to employ, both, time-domain as well as frequency-domain measurements at box 915. In particular, the time-domain measurements may be particularly suited to test relatively high frequencies; while the frequency-domain measurements may be particularly suited to test relatively small frequencies.

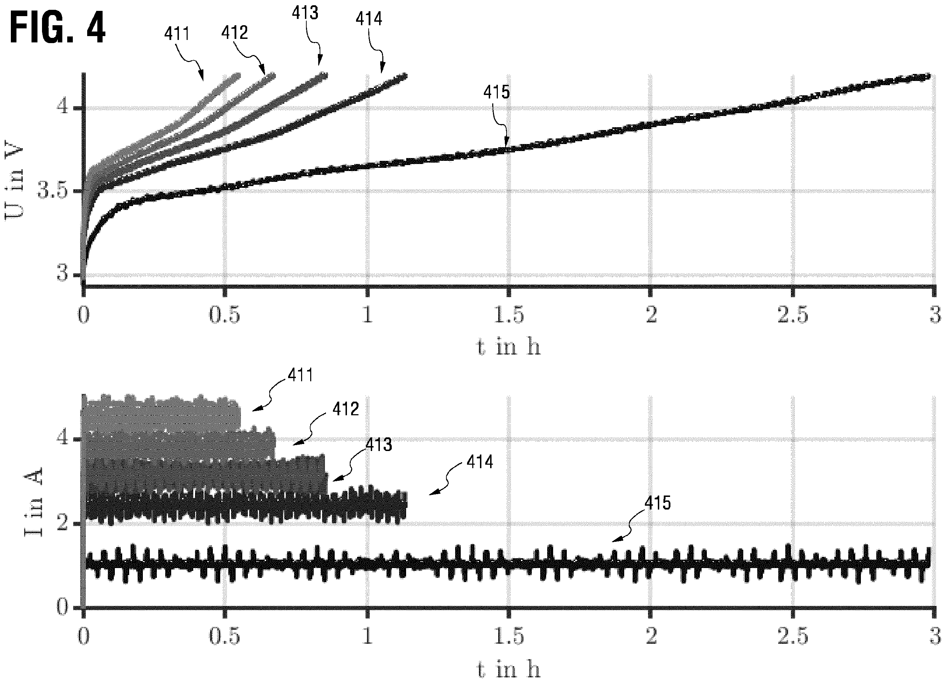

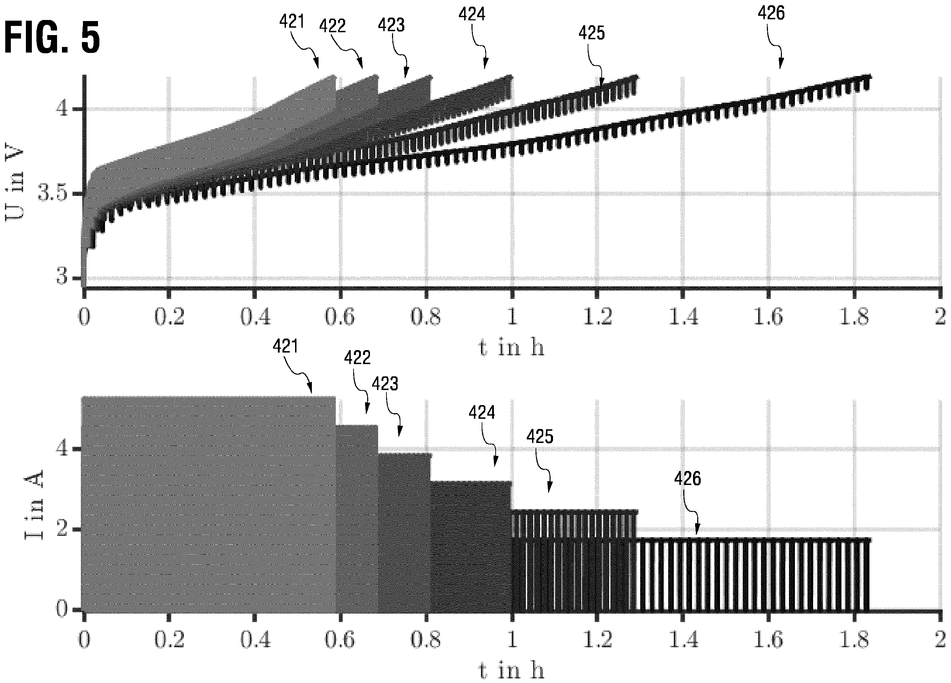

For instance, frequency-domain measurements 411-415 of voltage and current are illustrated in FIG. 4 (FIG 4, upper part: voltage measurement over time during a charging process, i.e., different points in time correspond to different SOCs; FIG. 4, lower part: current measurement over time during the same charging process, i.e., different points in time correspond to different SOCs). A constant current having a small, sinusoidal signal superimposed is applied to the LIB cell (the frequency of the sinusoidal signal is much higher if compared to the time resolution resolved along x-axis FIG. 4) The constant current has different amplitudes for the different measurements 411-415 (as can be seen from FIG. 4, lower part). The LIB cell is charged; thus, the SOC increases from left to right in FIG. 4. FIG. 5, on the other hand, illustrates time-domain measurements 421-426 voltage and current (FIG. 5, upper part: voltage measurement over time, for a sequence of charging pulses of a charging process; FIG. 5, lower part, current measurement over time for the same charging process). A sequence of current pulses is applied to the LIB cell. This charges the LIB cell. Thus, the SOC increases from left to right in FIG. 5. These current pulses have different amplitudes for the different measurements 421-426. In FIG. 4 and FIG. 5, the current amplitudes varied between 0.3C and 1.7C.

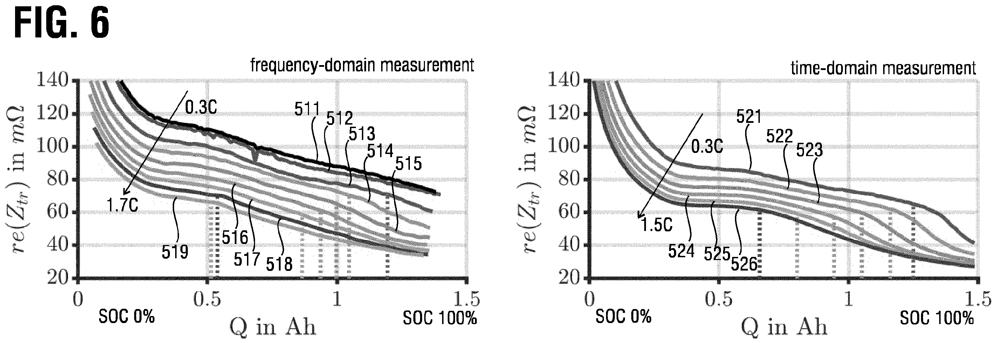

Based on such measurements 411-415, 421-426 it is then possible to calculate the impedance of the battery for the various current amplitudes as a function SOC. This is plotted in FIG. 6. The respective impedance values (real part) 511-519 are derived from frequency-domain measurements such as the measurements 411-415; while the impedance values (real part) 521-526 are derived from time-domain measurements: The impedance values are determined based on the time/frequency response for different times - i.e., at different SOCs - during the charging process (e.g., using a sliding window). The Lithium plating onset threshold SOC value (vertical dotted lines) has a characteristic pattern in these curves, i.e., a reduction of the slope. For instance, it is possible to calculate a derivative of the curves plotted in FIG. 6 to better extract these threshold SOC values.

Now referring again to FIG. 2: at box 920, it is then possible to determine multiple parameterized values of the ECM. In particular, an optimization may be performed, e.g., an iterative numerical optimization (e.g., gradient descent or another technique) that maximizes or minimizes a goal function, the goal function quantifying a difference between the measured frequency-resolved impedance values (cf. FIG. 3) and the modeled frequency-resolved impedance values.

At box 920, one or more constraints are considered. These one or more constraints can be routinely considered by optimization algorithms. These one or mode constraints are related to the electric potential of the negative electrode. In particular, the one or more constraints fix, at the respective current amplitudes and threshold SOC values, at which Lithium plating commences (cf. FIG. 6 vertical dotted lines) the electric potential of the negative electrode to the predefined Lithium reference potential. Since these one or more constraints selectively act on the negative electrode, the symmetry between the parameter values associated with the positive electrode of the parameter values associated with the negative electrode is broken; yielding better results for the ECM.

By testing multiple current amplitudes, multiple threshold SOC values are obtained. Generally, the accuracy of the ECM becomes better the more threshold SOC values are available.

Then, upon performing such optimization, the ECM is employed, at box 925. For instance, it would be possible to determine an optimized charging profile for Lithium ion batteries employing such cell type. For instance, the charging profile can be determined to enable fast charging while avoiding Lithium plating. Alternatively or additionally, a load constraint can be determined, i.e., while a current is drawn from the battery, certain operating constraints can be defined, e.g., in order to avoid increased aging of the LIB. Such charging profile or load constraints can then be deployed to battery management systems controlling operation of such Lithium-ion batteries.

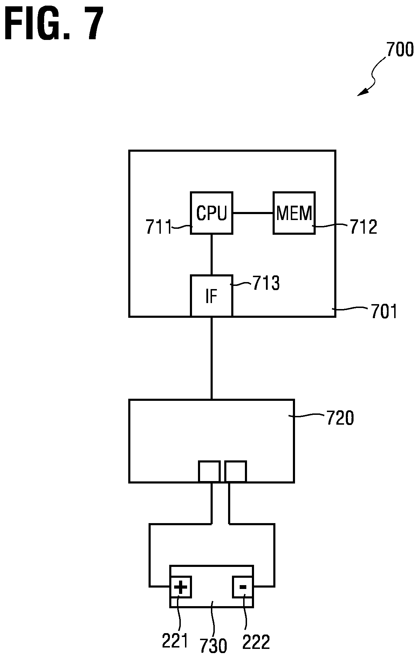

FIG. 7 schematically illustrates a system 700. The system 700 comprises a computing device 701. The computing device 701 includes a processor 711 and a memory 712 as well as a communication interface 713 (e.g., Ethernet). The processor 711 can load program code that is stored in the memory 712 and can execute the program code. The processor 711, upon executing the program code, performs techniques as disclosed herein, e.g., as previously discussed in connection with the flowchart of FIG. 2. In particular, the processor 711, upon executing the program code, can control the measurement equipment 720, e.g., to perform full-cell measurements on a LIB cell 730. The processor 711 can then post-process the measurement data, e.g., to determine impedance values as previously discussed in connection with the various FIGs. The measurement equipment 720 may be a "Cell Test System (CTS)" as sold by BaSyTec GmbH, Oellinger Weg 17, 89176 Asselfingen, Germany, or the like.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

For illustration, the techniques disclosed above can be executed for multiple temperatures. Then, a temperature dependency of the various electrochemical processes and the impedance values of the LIB can be captured in the ECM.

## Claims

1. A method of parameterizing an equivalent circuit model (200) of a Lithium-ion battery cell, the equivalent circuit model (200) comprising one or more respective resistor-capacitor elements (233, 234, 244, 243) for each of a positive electrode (211) of the Lithium-ion battery cell and a negative electrode (212) of the Lithium-ion battery cell,
wherein the method comprises:
- performing, for multiple state-of-charge values of the Lithium-ion battery cell, first full-cell measurements to determine, for each of the multiple state-of-charge values, a respective representation of frequency-resolved impedance values of the Lithium-ion battery cell,
- performing at least one second full-cell measurement (411-415, 421-426) to determine, for one or more current amplitudes, respective threshold state-of-charge values associated with an onset of Lithium plating, and
- performing an optimization of parameter values of the equivalent circuit model to fit the frequency-resolved impedance values, the optimization being performed under at least one constraint, the at least one constraint fixing, for the respective one or more current amplitudes and threshold state-of-charge values, a potential of the negative electrode to a predefined Lithium reference potential.

2. The method of claim 1,
wherein the at least one second full-cell measurement comprises multiple second full-cell measurements, each of the multiple second full-cell measurements being at a respective current amplitude, wherein at least some of the current amplitudes of the second full-cell measurements are larger than 0.5C.

3. The method of claim 1 or 2,
wherein the at least one second full-cell measurement comprises multiple second full-cell measurements,
wherein at least a first one (411-415) of the multiple second full-cell measurements (411-415, 421-426) is in time domain,
wherein at least a second one (421-426) of the multiple second full-cell measurements is in frequency domain.

4. The method of any one of the preceding claims,
wherein each of the at least one second full-cell measurement is at a respective frequency or frequency range,
wherein the method further comprises:
- determining, based on the representation of frequency-resolved impedance values of the Lithium-ion battery cell determined based on the first full-cell measurements, dominant electrochemical processes of the Lithium-ion battery cell, and
- setting the frequencies or frequencies ranges based on frequencies or frequency ranges of the dominant electrochemical processes.

5. The method of any one of the preceding claims,
wherein the representation of frequency-resolved impedance values comprises a time-domain distribution of relaxation times of the Lithium-ion battery cell.

6. The method of claim 5, further comprising:
wherein the time-domain distribution of relaxation times is expressed by a superposition of responses of an infinite number of resistor-capacitor elements with continuous relaxation times.

7. The method of any one of the preceding claims,
wherein the first full-cell measurements and the at least one second full-cell measurement are performed by tapping a positive terminal and a negative terminal of a customer-grade Lithium-ion battery cell.

8. The method of any one of the preceding claims,
wherein each of the at least one constraint breaks a symmetry between the parameter values of the positive electrode on the one hand and the parameter values of the negative electrode on the other hand.

9. The method of any one of the preceding claims,
wherein the one or more current amplitudes comprise at least one current amplitude that is larger than 0.5C or larger than 0.7C

10. The method of any one of the preceding claims, further comprising:
- upon performing the optimization of the parameter values: employing the equivalent circuit model to determine at least one of a charging profile or load constraints for a battery comprising battery cells of a same type as the Lithium-ion battery cell.

11. The method of any one of the preceding claims, further comprising:
- determining, based on the representation of frequency-resolved impedance values of the Lithium-ion battery cell, a count of dominant electrochemical processes, and
- setting a count of the respective resistor-capacitor elements for each of the positive electrode of the Lithium-ion battery cell and the negative electrode of the Lithium-ion battery cell based on the count of the dominant electrochemical processes.

12. The method of any one of the preceding claims,
wherein the negative electrode comprises Graphite.

13. A computing device (701) comprising at least one processor (711) and a memory (712), the at least one processor being configured to load program code from the memory and to execute the program code,
wherein the at least one processor, upon executing the program code:
- controls at least one measurement equipment (720) to perform, for multiple state-of-charge values of a Lithium-ion battery cell, first full-cell measurement and determines, for each of the multiple state-of-charge values, a respective representation of frequency-resolved impedance values of the Lithium-ion battery cell,
- controls the at least one measurement equipment to perform at least one second full-cell measurement and determines, for one or more current amplitudes, respective threshold state-of-charge values associated with an onset of Lithium plating,
- performs an optimization of parameter values of an equivalent circuit model, the equivalent circuit model (200) comprising one or more respective resistor-capacitor elements (233, 234, 244, 243) for each of a positive electrode (211) of the Lithium-ion battery cell and a negative electrode (212) of the Lithium-ion battery cell, the optimization fitting the frequency-resolved impedance values, the optimization being performed under at least one constraint, the at least one constraint fixing, for the respective one or more current amplitudes and threshold state-of-charge values, a potential of the negative electrode to a predefined Lithium reference potential

14. The computing device of claim 13, wherein the at least one processor, upon executing the program code, performs the method of any one of claims 1 to 12.

15. A system /700) comprising the computing device of claim 13 or 14, the at least one measurement equipment and optionally the Lithium-ion battery cell.
